Europäisches Patentamt

European Patent Office

Office européen des brevets

(11) Publication number: **0 116 343**
**B1**

# EUROPEAN PATENT SPECIFICATION

(45) Date of publication of patent specification: **01.06.88**

(51) Int. Cl.⁴: **G 03 F 7/26**

(21) Application number: **84101068.9**

(22) Date of filing: **02.02.84**

(54) **Photoresist stripper composition and method of use.**

(30) Priority: **14.02.83 US 465975**

(43) Date of publication of application:
**22.08.84 Bulletin 84/34**

(45) Publication of the grant of the patent:
**01.06.88 Bulletin 88/22**

(84) Designated Contracting States:
**BE CH DE FR GB IT LI NL SE**

(56) References cited:
**EP-A-0 011 658**
**GB-A-2 069 995**
**US-A-3 789 007**
**US-A-3 813 309**
**US-A-3 988 256**
**US-A-4 211 560**

(73) Proprietor: **THE DOW CHEMICAL COMPANY**
**2030 Dow Center Abbott Road P.O. Box 1967**
**Midland, MI 48640 (US)**

(72) Inventor: **Archer, Wesley L.**
**1117 Scott Street**
**Midland Michigan 48640 (US)**
Inventor: **Dallessandro, Susan M.**
**4212 Swede**
**Midland Michigan 48640 (US)**
Inventor: **Lynn, Vicki A.**
**5307 Channing Road**
**Indianapolis Indiana 46226 (US)**

(74) Representative: **Weickmann, Heinrich, Dipl.-Ing.**
**et al**
**Patentanwälte Dipl.-Ing. H.Weickmann Dipl.-**
**Phys.Dr. K.Fincke Dipl.-Ing. F.A.Weickmann**
**Dipl.-Chem. B. Huber Dr.-Ing. H. Liska Dipl.-**
**Phys.Dr. J. Prechtel Postfach 860820**
**D-8000 München 86 (DE)**

Courier Press, Leamington Spa, England.

## Description

This invention relates to formulations useful as photoresist stripper formulations, and to methods of removing photoresist materials by use of the formulations of the invention.

Printed circuit boards are typically manufactured by plating a thin layer of copper on an epoxy-glass cloth laminate board or mica board of uniform thickness. A predetermined pattern of holes is then drilled to accommodate various electrical components. A film of partially polymerized photoresist plastic is deposited on the laminate over the copper plating. These photoresist films are commonly composed of acrylic resins, polyvinyl cinnamates, diazo compounds, phenol-formaldehydes, or other similar film-forming materials. This film is further polymerized, or crosslinked, by the action of ultraviolet light, into a hard chemically resistant film.

By masking with an appropriate glass or plastic material the resist film is selectively hardened by the exposure to light in specific predetermined areas, while the resist film in the masked areas is left unchanged. The unchanged resist film is then dissolved in a "developer" by a solvent such as 1,1,1-trichloroethane or a solution of butoxyethanol and sodium carbonate or similar solutions. The copper in the cleaned areas may then be removed by etching or additional copper and other metals may be plated thereon. In either event, it then becomes necessary to remove the exposed hardened resist film from the laminate.

It is known that such resist films can be removed by the action of strong organic solvents, such as methylene chloride or trichloroethylene.

It is known also that many paint and varnish removers are based on dichloromethane. Many of these also contain an alcohol and one or more other additives. Thus, U.S.—A—3,650,969 discloses a composition for removing paint which comprises dichloroalkanes of 1 to 2 carbon atoms, an aliphatic monohydric alcohol containing 1 to 3 carbon atoms, and hydrogen fluoride and water. U.S.—A—3,600,322 discloses a paint remover composition containing dichloromethane, methanol and a quaternary nitrogen cellulose ether.

Other patents employing dichloromethane with alkanols and various other additives are U.S.—A—3,147,224; 3,075,923; 4,269,724 and 4,278,557.

A method of removing resist from printed circuit boards is described in U.S.—A—3,789,007 wherein the board is treated with a mixture of 85 to 97 percent by weight of dichloromethane with the balance being methanol.

EP—A—0 011 658 describes a stabilized solvent composition suitable for vapor degreasing of aluminum parts which comprises methylene chloride and as the stabilizer methyl or ethyl formate or mixtures thereof.

US—A—4 211 560 describes compositions for the use as liquid developer to dissolve or disperse unexposed areas of the photopolymerizable layer. As specific examples of an organic solvent as the developer, there are mentioned ketones such as acetone and methyl ethyl ketone; esters such as methyl formate, methyl acetate, ethyl acetate and amyl acetates; chlorinated hydrocarbons such as chloroform, trichloroethylene, 1,1,1-trichloroethane, 1,1,2-trichloroethane and methylene chloride; aromatic hydrocarbons such as benzene, toluene and xylene; alicyclic hydrocarbons such as cyclohexane; alcohols such as methanol, ethanol and isopropanol; cellosolves such as methyl cellosolve; and tetrahydrofuran, which may be used either alone or in mixture.

Other photoresist stripper compositions containing dichloromethane are disclosed in U.S.—A—3,625,763; 3,813,309 and 3,625,763.

GB—A—2 069 995 describes a degreasing agent for metal surfaces consisting essentially of a mixture of dichloromethane and, as a stabilizer, an effective amount of methyl alcohol, together with a trace amount of at least one of diisopropylamine, benzylethylamine and triethylamine.

The present invention is an improved photoresist stripper composition which contains dichloromethane (methylene chloride), methanol and methyl methanoate (methyl formate). This combination strips the resist at a faster rate than prior art compositions. The preferred compositions also provide a non-flashing mixture (blend) and give better line definition than currently available commercial strippers.

Subject of the present invention is a composition suitable for stripping crosslinked photoresist polymer according to Claim 1, and a process for stripping crosslinked photoresist polymer which employs a mixture of dichloromethane and methanol the improvement of which comprises employing a composition according to the present invention.

Preferred embodiments of the composition are subject of Claims 2 to 8.

The composition can optionally contain a stabilizer for the dichloromethane such as a vicinal epoxide, e.g. propylene oxide. Amines are frequently used as an aid in stripping, e.g. isopropylamine. Also useful are cyclohexylamine and triethylamine. Such amines are known to be contained in some current commercial stripper formulations.

Blends according to the invention were tested in the following ways:

Test 1 — Drop Test

A fifty microliter drop of the test blend (1—25 percent additive(s) in dichloromethane) is placed on the

# 0 116 343

crosslinked photoresist film contained on a printed circuit board. The solvent-film area is observed under a 150X microscope to determine the time (in seconds) necessary to fracture and lift the film from the board. Shorter times are preferred in commercial operations.

This test was run with a number of possible additive candidates using commercially-prepared photoresist-covered printed circuit boards. These boards utilized a crosslinked photoresist film, commercially available from E. I. duPont de Nemours Co., Inc. Results from these tests are shown in Tables I and II. All of the additives were tested in an inhibited grade of dichloromethane chloride to which was added 0.1 volume percent 2-aminopropane (isopropylamine).

TABLE I*

| Additive** | Drop Time (sec) | | | | |
|---|---|---|---|---|---|
| (%) | 5 | 7.5 | 10 | 15 | 25 |
| Me Me | 8.3 | 8.8 | 10.1 | 11.3 | 10.2 |
| MeOH | 10.3 | 10.0 | 9.6 | 10.4 | 11.5 |
| 2-PrOH | 11.7 | 12.5 | 12.8 | 14.1 | 16.7 |
| Me Et | 13.1 | 13.2 | 13.5 | 15.9 | 20.0 |

TABLE II*

| Additive** | Drop Time (sec) | | | |
|---|---|---|---|---|
| (%) | 5 | 7.5 | 10 | 15 |
| Me Me | 11.8 | 12.5 | 12.8 | 14.5 |
| Et Me | 14.8 | 15.0 | 15.3 | 16.5 |
| MeOH | 12.4 | 12.3 | 12.2 | 11.4 |
| 2-PrOH | 12.1 | 12.3 | 13.1 | 13.4 |
| Me Et | 14.2 | 14.9 | 15.0 | 18.0 |
| THF | 12.7 | 12.5 | 13.3 | 16.4 |

*Table I shows results using a commercially available polymethylmethacrylate film and Table II a similar, but not identical film, manufactured by the same company.
**MeOH = methanol
2-PrOH = 2-propanol (isopropyl alcohol)
Me Me = methyl methanoate
Me Et = methyl ethanoate (methyl acetate)
Et Me = ethyl methanoate (ethyl formate)
THF = tetrahydrofuran

Test 2 — Spray Unit Test

A spray test was conducted utilizing a steel spray unit which was a laboratory scale version of the apparatus used in industry to strip resist film. Two-gallon (7.6 liter) quantities of test blends suggested from the preliminary screening were used in the spray unit. Solvent spray at 20 psig (138 kPa guage) and 23—24°C was then directed onto the suspended boards for 10—15 seconds. The boards were weighed before and after stripping. Weight differences in amount of removed photoresist were compared with a standard stripper formulation using the formula:

$$\% \text{ difference} = \frac{\text{wt. test blend} - \text{wt. standard}}{\text{wt. standard}} \times 100$$

A positive percent value indicated more complete stripping and a negative value less complete stripping when compared with the performance of the standard stripper blend. The standard was a commercially available stripper containing 7.5 percent methanol and 0.10 percent 2-aminopropane in dichloromethane (inhibited grade), volume basis.

**0 116 343**

The 4 inch × 4 inch (102 × 102 mm) test boards were prepared by a commercial fabricator, using a commercially available photoresist resin film (the major component of which is a polymethylmethacrylate resin) and a test pattern consisting of numerous lines of varying widths and spacing. These boards, which were tin-lead plated, were ready for stripping as received.

Several compositions of dichloromethane containing different amounts of methanol and methyl methanoate were used in the above described spray test. A timed spray of 10-second duration was used. Methanol and methyl methanoate were each employed in amounts of 1.0, 2.5 and 4.0 volume percent in the dichloromethane (inhibited grade) based on the total volume of solvent and additives. 2-Aminopropane was present at 0.1 volume percent in each formulation total basis. Results of strippability of each formulation are shown as percent better (+) or worse (−) than a standard methylene chloride stripper in Table III.

TABLE III

| % Me Me | % MeOH | | |
|---------|--------|------|------|
|  | 1.0 | 2.5 | 4.0 |
| 1.0 | −17.5 | −10.7 | +7.4 |
| 2.5 | −1.6 | +13.8 | +13.2 |
| 4.0 | +5.3 | +4.4 | +4.4 |

Evaporation and corrosion tests were also performed on these compositions.

Two tests were done for evaporation. In the first, 300 ml of test solution was prepared, placed in a beaker at room temperature in a hood, and analyzed at various times for additive composition using gas chromatography. Results are shown in Table IV. In the second test, two gallons (7.6 liters) of test solution were placed in the spray unit with the lid slightly opened. The unit was operated at 20 psig (138 kPa gauge) for a period of 60 minutes. Again, the concentration of the additives were evaluated at various times. For this test at the end of one hour the concentration of methyl methanoate was about 2.85 percent and that of the methanol was about 2.30 percent, the initial concentrations being 3.0 volume percent each, which showed only slight loss of components from the mixture.

TABLE IV
*Composition (Vol.%)

| Time (min.) | MeOH | Me Me | Volume (ml) |
|-------------|------|-------|-------------|
| 0 | 3.00 | 3.00 | 300 |
| 20 | 2.80 | 2.85 | 275 |
| 60 | 2.55 | 2.80 | 215 |
| 90 | 2.45 | 2.85 | 175 |
| 120 | 2.00 | 2.75 | 140 |
| 153 | 1.60 | 2.70 | 100 |

*This composition also contained 0.1% 2-aminopropane by volume, but since its levels were unimportant with respect to strippability its analysis was omitted.

A copper corrosion study consisted of refluxing 100 ml of test solvent blend with a 0.5 × 2.45 inch (12.7 × 62.2 mm) copper coupon for seven days. Triplicate determinations were run for each solvent blend. Gas chromatography analysis was done on each sample after the seven days. The corrosion rate of the copper coupon was expressed in mils penetration per year (MPY) (1 mil = 0.0254 mm) using the following formula

$$MPY = \text{coupon wt (mg) loss/sq in/day (22.3/8.93)}$$

$$MPY = \frac{\text{wt (MG) loss (22.3)}}{2.45(7)(8.93)}$$

4

Results for formulations of a commercial blend (A) and one according to the invention (B) under the conditions of the above test are shown below.

| Formulation (Vol.%) | | | Corrosion (MPY) | (mm/year) |
|---|---|---|---|---|
| A | MeOH | 7.5 | 1.01 | 0.0256 |
| | 2-AP* | 0.1 | | |
| B | MeOH | 2.5 | | |
| | Me Me | 2.5 | 0.1 | 0.0025 |
| | 2-AP* | 0.1 | | |

*2-aminopropane

The amine can present a slight problem of copper tarnishing and solvent discoloration if allowed to stand for a minimum of 12 hours at room temperature in the presence of the metal. This may not be a significant problem with respect to the boards, however, since the solvent contacts the copper circuit boards for only two to three minutes in actual commercial use. Since industrial equipment typically uses copper piping, however, this phenomenon can effect equipment life. It is interesting to note that use of a 0.1 volume percent triethylamine to replace 2-aminopropane in the B formulation greatly decreased the solvent discoloration problem in the room temperature copper corrosion tests. The amine, in such a low concentration, adds nothing to the strippability characteristics of the formulation and if eliminated completely avoids the corrosion and discoloration of the copper.

The compositions according to the present invention are those containing from about 1 to about 10 volume percent each of methanol and methyl methanoate, with the priviso that the total of methanol and methyl methanoate be at least 5 and not more than about 10 volume percent of the total composition. The composition may also contain an amine.

## Claims

1. A composition suitable for stripping crosslinked photoresist polymer which comprises dichloromethane containing methanol and methyl formate, each in amounts of from 1 to 10 percent by volume of the total mixture, providing that the total amount of methanol and methyl formate is at least 5 and not more than 10 volume percent of the total mixture.

2. The composition of Claim 1 wherein the methanol and methyl formate are each present in an amount of from 1 to 5 volume percent of the total mixture.

3. The composition of Claim 2 wherein the methanol and methyl formate are present at 2.5 to 5 volume percent each.

4. The composition of any of Claims 1 to 3 which additionally contains an amine.

5. The composition of Claim 4 wherein the amine is a lower aliphatic amine having from 3 to 6 carbon atoms.

6. The composition of Claim 4 wherein the amine is 2-aminopropane.

7. The composition of Claim 4 wherein the amine is cyclohexylamine.

8. The composition of Claim 4 wherein the amine is triethylamine.

9. A process for stripping crosslinked photoresist polymer which employs a mixture of dichloromethane and methanol the improvement of which comprises employing a composition of any one of Claims 1 to 8.

## Patentansprüche

1. Zusammensetzung, die geeignet ist zur Entschichtung von quervernetztem Photolackpolymer, umfassend Dichlormethan enthaltendes Methanol und Methylformiat, jeweils in Mengen von 1 bis 10% bezogen auf das Volumen der Gesamtmischung, vorausgesetzt, daß die Gesamtmenge an Methanol und Methylformiat mindestens 5 und höchstens 10 Vol.-% der Gesamtmischung darstellt.

2. Zusammensetzung nach Anspruch 1, worin das Methanol und das Methylformiat jeweils in einer Menge von 1 bis 5 Vol.-% der Gesamtmischung vorhanden sind.

3. Zusammensetzung nach Anspruch 2, worin das Methanol und das Methylformiat jeweils zu 2,5 bis 5 Vol.-% vorhanden sind.

4. Zusammensetzung nach einem der Ansprüche 1 bis 3, zusätzlich enthaltend ein Amin.

5. Zusammensetzung nach Anspruch 4, worin das Amin ein niedriges aliphatisches Amin mit 3 bis 6 Kohlenstoffatomen ist.

6. Zusammensetzung nach Anspruch 4, worin das Amin 2-Aminopropan ist.

7. Zusammensetzung nach Anspruch 4, worin das Amin Cyclohexylamin ist.

8. Zusammensetzung nach Anspruch 4, worin das Amin Triethylamin ist.

9. Verfahren zur Entschichtung von quervernetzten Photolackpolymeren, in dem eine Mischung von Dichlormethan und Methanol verwendet wird, und die Verbesserung darin besteht, daß man eine Zusammensetzung nach einem der Ansprüche 1 bis 8 verwendet wird.

**Revendications**

1. Composition appropriée pour éliminer par dissolution une résine polymère photosensible reticulée, qui comprend du dichlorométhane contenant du méthanol et du formiate de méthyle, chacun dans des proportions de 1 à 10% en volume du mélange total, à condition que la quantité totale de méthanol et de formiate de méthyle soit d'au moins 5 et d'au plus 10% en volume du mélange total.

2. Composition selon la revendication 1, dans laquelle le méthanol et le formiate de méthyle sont présents chacun dans une proportion de 1 à 5% en volume du mélange total.

3. Composition selon la revendication 2, dans laquelle le méthanol et le formiate de méthyle sont présents chacun dans une proportion de 2,5 à 5% en volume.

4. Composition selon l'une quelconque des revendications 1 à 3, contenant en outre une amine.

5. Composition selon la revendication 4, dans laquelle l'amine est une amine aliphatique inférieure, comportant de 3 à 6 atomes de carbone.

6. Composition selon la revendication 4, dans laquelle l'amine est le 2-aminopropane.

7. Composition selon la revendication 4, dans laquelle l'amine est la cyclohexylamine.

8. Composition selon la revendication 4, dans laquelle l'amine est la triéthylamine.

9. Dans un procédé pour éliminer par dissolution une résine polymère photosensible réticulée, qui utilise un mélange de dichlorométhane et de méthanol, le perfectionnement qui consiste en l'emploi d'une composition selon l'une quelconque des revendications 1 à 8.